# EUROPEAN PATENT APPLICATION

(11) **EP 4 283 874 A1**
(43) Date of publication of application: **29.11.2023**
(21) Application number: 22884924.6
(22) Date of filing: 01.03.2022
(51) Int. Cl.: H03K 7/08

(54) **PULSE WIDTH CLOCK TOPOLOGY STRUCTURE CIRCUIT**

(30) Priority: 29.10.2021 CN 202111275488
(71) Applicant: Shanghai Yijiaxin Integrated Circuit Design Co., Ltd., Shanghai 201306 (CN)
(72) Inventor: JIANG, Xiaowei, Shanghai 201306 (CN); BAO, Xinggang, Shanghai 201306 (CN)
(74) Representative: Boult Wade Tennant LLP
(86) International application number: PCT/CN2022/078669
(87) International publication number: WO 2023/071007

(57) **Abstract**

A pulse width clock topology structure circuit, comprising a clock pulse width generation module and a clock topology delay module. The clock pulse width generation module connects an input clock and n stages of delay sub-modules in series; an output end of each stage of delay sub-module is connected to an input end of a selector; a certain required delay clock is selected by means of m+1 control signals of the selector, and an "AND" operation is performed on the required delay clock and an original input clock to generate different pulse width clock outputs as inputs of the clock topology delay module; and the clock topology delay module can generate a plurality of different delay clocks for different latches to use.

## Description

### TECHNICAL FIELD

The present invention relates to a pulse width clock topological structure circuit, which is suitable for chips of Central Processing Unit (CPU), Graphics Processing Unit (GPU), asynchronous operation core unit module and Digital Signal Processor (DSP) operation module.

### BACKGROUND OF THE INVENTION

In digital circuit design, edge-triggered register units are widely used. Edge-triggered registers are mainly composed of 2-stage latches (Data Flip-Flop, DFF). Edge-triggered registers have the advantages of anti-noise effect, anti-glitch, not easy to lose stored data, simple timing design and perfect test verification method. However, the disadvantages are that the integration is low, and area, power consumption and performance cannot meet the requirements of high-performance circuits.

By controlling the clock to achieve a "micro" width high or low level (i.e., pulse clock), the latch works in an "edge-triggered" manner, thereby solving the problems of the power consumption, performance and area (PPA) of the register to meet the chip with high design requirements.

The performance of the traditional method needs to be further improved to meet the needs of users.

### SUMMARY OF THE INVENTION

The object of the present invention is to provide a pulse width clock topology structure circuit to solve the problems raised in the above prior art.

To achieve the above object, the present invention provides the following technical solutions:
A pulse width clock topology structure circuit, comprising: a clock pulse width generation module and a clock topology delay module;
the clock pulse width generation module connects an input clock and n stages of delay sub-modules in series; an output end of each stage of delay sub-module is connected to an input end of a selector; a certain required delay clock is selected by means of m+1 control signals of the selector, and an "AND" operation is performed on the required delay clock and an original input clock to generate different pulse width clock outputs as inputs of the clock topology delay module; and the clock topology delay module can generate a plurality of different delay clocks for different latches to use, wherein n>1, and 2^{(m + 1)} ≥ n.

As a further solution of the present invention: the delay sub-module delays for a certain time, and the certain time delayed by each of the delay sub-modules is equal or unequal.

As a further solution of the present invention: the delay sub-module includes an odd number of inverters and several buffers, wherein the inverters and the buffers are connected to each other or alternately connected.

As a further solution of the present invention: the total delay delayed by the n stages of delay sub-modules is less than a pulse width of the input clock.

As a further solution of the present invention: an input end of a first stage of the n stages of delay sub-modules is connected to the original input clock, and input ends of a second stage to nth stage of the n stages of delay sub-modules are connected to an output end of a previous stage of the delay sub-modules.

As a further solution of the present invention: the "AND" operation is performed on an output end of the selector and the original input clock to generate clocks with different pulse widths as required.

As a further solution of the present invention: the clock topology delay module consists of clock signals with different delays to form a topology structure.

As a further solution of the present invention: a delay time of each latch of the clock topology delay module is consistent to achieve a clock balance function.

Compared with the prior art, the beneficial effect of the present invention is that the pulse width clock topology structure circuit has a higher performance.

The pulse width clock topology structure circuit can effectively control the delay rate of the clock, so that each input clock has a certain delay to meet the stringent requirements of the pulse width for signal integrity.

### BRIEF DESCRIPTION OF THE DRAWINGS

Fig. 1 is a perspective view of a pulse width clock topology structure circuit as a first embodiment of the present invention;
Fig. 2 is a perspective view of a pulse width clock topology structure circuit as a second embodiment of the present invention; and
Fig. 3 is a perspective view of a clock pulse width generation module and a clock topology delay module of the pulse width clock topology structure circuit of the present invention.

### DETAILED DESCRIPTION OF THE INVENTION

The following will clearly and completely describe the technical solutions in the embodiments of the present invention with reference to the drawings. Apparently, the described embodiments are only some rather than all of the embodiments of the present invention. Based on the embodiments of the present invention, all other embodiments obtained by persons of ordinary skill in the art without making creative efforts belong to the protection scope of the present invention.

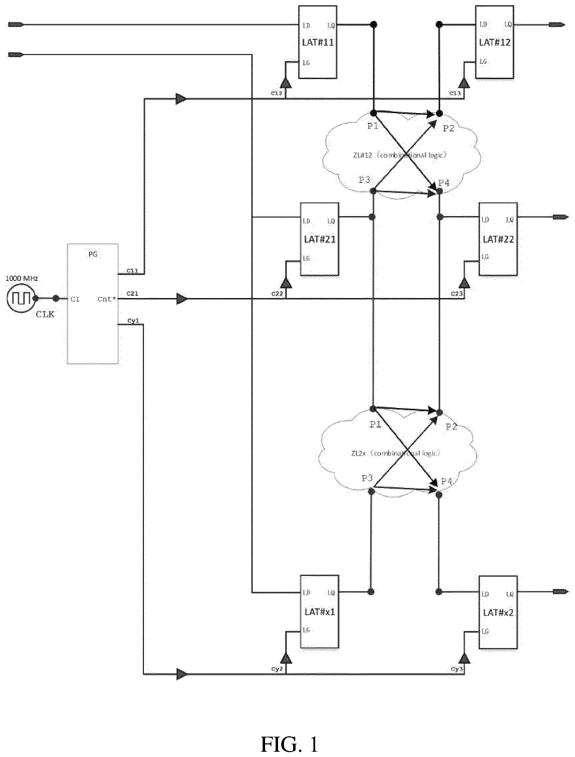

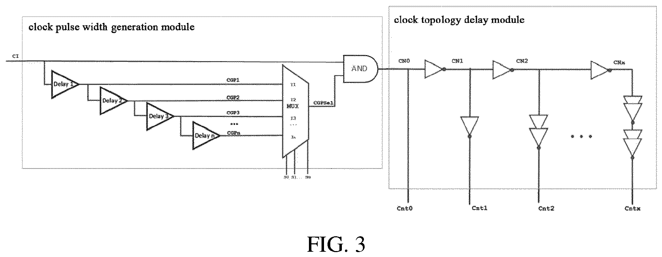

As shown in Figs. 1 to 3, a pulse width clock topology structure circuit includes: a clock pulse width generation module and a clock topology delay module.

The clock pulse width generation module connects an input clock and n stages of delay sub-modules (Delay) in series, and an output end of each stage of delay sub-module is connected to an input end of a selector (MUX). A certain required delay clock is selected by m+1 control signals of the selector (MUX), and an "AND" operation is performed on the required delay clock and an original input clock (CI) to generate different pulse width clock outputs as inputs of the clock topology delay module, and the clock topology delay module can generate a plurality of different delay clocks for different latches to use, wherein n>1, and 2^{(m + 1)} ≥ n.

As a specific implementation, the delay sub-module (Delay) delays for a certain time, and the certain time delayed by each of the delay sub-modules (Delay) may be equal or unequal.

As a specific implementation, the delay sub-module (Delay) includes an odd number of inverters (N) and several buffers (Buffer), wherein the inverters and buffers are connected to each other or alternately connected.

As a specific implementation, the total delay delayed by the n stages of delay sub-modules (Delay) is less than a pulse width of the input clock.

As a specific implementation, an input end of a first stage of the n stages of delay sub-modules (Delay) is connected to the original input clock (CI), and input ends of a second stage to nth stages of the n stages of delay sub-modules (Delay) are connected to an output end of a previous stage of the delay sub-modules (Delay).

As a specific implementation, the "AND" operation is performed on an output end of the selector (MUX) and the original input clock to generate clocks with different pulse widths as required.

As a specific implementation, the clock topology delay module consists of clock signals (CntO, Cnt1 ... Cntx) with different delays to form a topology structure.

As a specific implementation, a delay time of each latch of the clock topology delay module is consistent to achieve a clock balance function.

The clock pulse width generation module connects the original input clock (CI) and n stages of delay sub-modules (Delay) in series, where the delay sub-module has a specific delay function, and is composed of an odd number of inverters (N) and several buffers (Buffer) connected to each other or alternately connected. In addition, the output end of each stage of delay sub-module is output to the input end of the selector (MUX), and a certain required delayed clock is selected by means of m+1 control signals of the selector (MUX), and an "AND" operation is performed with the original input clock (CI) to generate different pulse width clock outputs as inputs of the clock topology delay module, the clock topology delay module capable of generating x different delay clocks. The pulse width clock topology structure circuit can effectively control the delay rate of the clock, so that each input clock has a certain delay to meet the stringent requirements of the pulse width for signal integrity.

Fig. 1 shows a relatively simple first embodiment. The output ends (CntO, Cnt1... Cntx) of the topology clock connect the required y clock signals (C11, C21... Cy1) to x output ends of the topology clock (and x ≥ y), and the y clock signals (C11, C21... Cy1) are respectively provided to the latches (LAT#) that require different delay clocks.

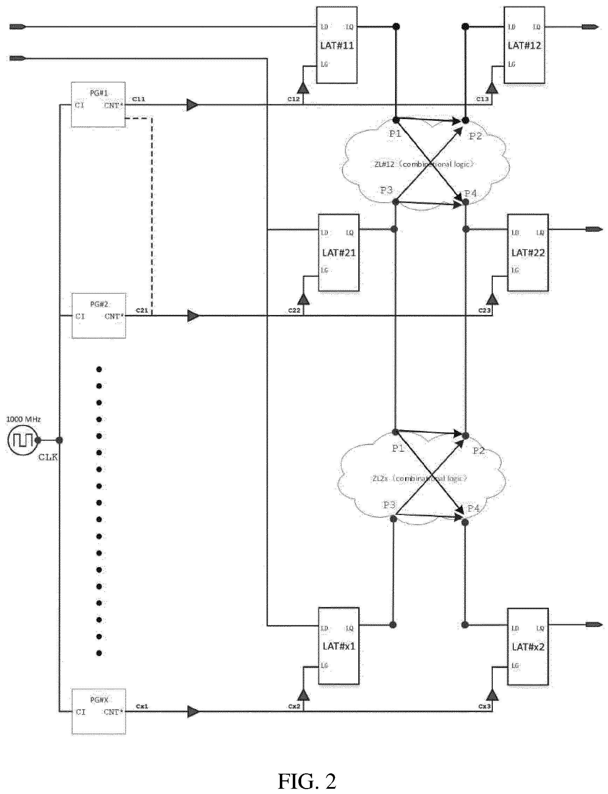

Fig. 2 shows a relatively complex second embodiment. One or more of the output ends (CntO, Cnt1... Cntx) of the topology clock (Pulse Generator (PG) module) are connected to the required y clock signals (C11, C21... Cy1), in which y clock signals (C11, C21... Cy1) are provided to the latches (LAT#) that require different delay clocks.

It will be apparent to those skilled in the art that the invention is not limited to the details of the above-described exemplary embodiments, but that the invention can be embodied in other specific forms without departing from the spirit or essential features of the invention. Therefore, no matter from which point of view, all the embodiments should be regarded as exemplary and non-restrictive, and the scope of the present invention is defined by the appended claims rather than the above description, so all changes within the meaning and scope of the equivalent elements of the claims are intended to be included in the present invention. Any reference sign in a claim should not be construed as limiting the claim concerned.

In addition, it should be understood that although this description is described according to implementation modes, not each implementation mode only includes an independent technical solution. The description is drafted in such a manner as only for clarity, those skilled in the art should take the description as a whole, and the technical solutions in the various embodiments can also be appropriately combined to form other implementation modes that can be understood by those skilled in the art.

## Claims

1. A pulse width clock topology structure circuit, comprising: a clock pulse width generation module and a clock topology delay module, **characterized in that**,
the clock pulse width generation module connects an input clock and n stages of delay sub-modules in series; an output end of each stage of delay sub-module is connected to an input end of a selector; a certain required delay clock is selected by means of m+1 control signals of the selector, and an "AND" operation is performed on the required delay clock and an original input clock to generate different pulse width clock outputs as inputs of the clock topology delay module; and the clock topology delay module can generate a plurality of different delay clocks for different latches to use, wherein n>1, and 2^{(m + 1)} ≥ n.

2. The pulse width clock topology structure circuit according to Claim 1, **characterized in that**,
the delay sub-module delays for a certain time, and the certain time delayed by each of the delay sub-modules is equal or unequal.

3. The pulse width clock topology structure circuit according to Claim 2, **characterized in that**,
the delay sub-module includes an odd number of inverters and several buffers, wherein the inverters and the buffers are connected to each other or alternately connected.

4. The pulse width clock topology structure circuit according to Claim 1, **characterized in that**,
the total delay delayed by the n stages of delay sub-modules is less than a pulse width of the input clock.

5. The pulse width clock topology structure circuit according to Claim 1, **characterized in that**,
an input end of a first stage of the n stages of delay sub-modules is connected to the original input clock, and input ends of a second stage to nth stage of the n stages of delay sub-modules are connected to an output end of a previous stage of the delay sub-modules.

6. The pulse width clock topology structure circuit according to Claim 1, **characterized in that**,
the "AND" operation is performed on an output end of the selector and the original input clock to generate clocks with different pulse widths as required.

7. The pulse width clock topology structure circuit according to Claim 1, **characterized in that**,
the clock topology delay module consists of clock signals with different delays to form a topology structure.

8. The pulse width clock topology structure circuit according to Claim 1, **characterized in that**,
a delay time of each latch of the clock topology delay module is consistent to achieve a clock balance function.
